(19) Europäisches Patentamt
European Patent Office
Office européen des brevets

(11) **EP 3 244 528 B1**

(12) **EUROPEAN PATENT SPECIFICATION**

(45) Date of publication and mention
of the grant of the patent:
**23.09.2020 Bulletin 2020/39**

(21) Application number: **15876866.3**

(22) Date of filing: **09.01.2015**

(51) Int Cl.:
*H02P 6/16* (2016.01)   *G01D 5/12* (2006.01)
*G01R 31/50* (2020.01)

(86) International application number:
**PCT/JP2015/050427**

(87) International publication number:
**WO 2016/110989 (14.07.2016 Gazette 2016/28)**

(54) **POWER CONVERSION DEVICE AND CONTROL METHOD FOR POWER CONVERSION DEVICE**

LEISTUNGSWANDLER UND STEUERUNGSVERFAHREN FÜR LEISTUNGSWANDLER

DISPOSITIF DE CONVERSION DE PUISSANCE ET PROCÉDÉ DE COMMANDE DE DISPOSITIF
DE CONVERSION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.11.2017 Bulletin 2017/46**

(73) Proprietor: **Hitachi Industrial Equipment Systems
Co., Ltd.
Tokyo 101-0022 (JP)**

(72) Inventor: **ONUMA Yusaku
Tokyo 101-0022 (JP)**

(74) Representative: **Strehl Schübel-Hopf & Partner
Maximilianstrasse 54
80538 München (DE)**

(56) References cited:
**EP-A1- 2 242 173**   **EP-A1- 2 372 313**
**JP-A- H05 176 419**   **JP-A- H08 336 299**
**JP-A- 2001 119 974**   **JP-A- 2007 185 006**
**JP-A- 2009 050 124**   **JP-A- 2009 270 978**
**JP-A- 2010 276 417**   **US-A- 5 355 749**

EP 3 244 528 B1

**Description**

## TECHNICAL FIELD

The present invention relates to a power conversion device and a control method for the power conversion device.

## BACKGROUND ART

JP-H9-5114 A (PATENT LITERATURE 1) is available as a background art in this technical field. This publication discloses "a circuit in which by the instruction of the serial signal from the outside, the encoder parameters such as the number of pulses, the number of poles, the recognition number of the rotary encoder, and the parameters of the equipment such as a motor such as numbers, the induced voltage constant, the moment of inertia, the viscosity coefficient, and their temperature coefficients of the equipment such as the motor to be mounted are read and stored in ROM or electrically rewritable ROM or nonvolatile RAM or RAM backed up by a battery" (See Claim 1). This publication also discloses "the number of pulses of the rotary encoder and information on equipment such as the motor to be mounted is manually input by the receiver" (See TECHNICAL PROBLEM).

The document US 2 242 173 A1 discloses a control device capable of detecting faulty Hall cells in an encoder The document US 5,455, 749 discloses a power conversion device for driving a motor equipped with a rotational speed sensor. The signals of the rotational speed sensor are used for a feedback control minimizing a deviation between a target motor rotational speed and an actual motor rotational speed. Further related control apparatuses are disclosed e.g. in the documents JP 2007 185006 A, JP 2010 276417 A and JP H08 336299 A.

## CITATION LIST

## PATENT LITERATURE

PATENT LITERATURE 1: JP-H9-5114A
PATENT LITERATURE 2: JP-H6-105580A
PATENT LITERATURE 3: JP-2001-251889A

## SUMMARY OF INVENTION

## TECHNICAL PROBLEM

In the technique of PATENT LITERATURE 1, the rotary encoder is required to be provided with a circuit for storing the parameters of the encoder such as the number of pulses.

Also, as a conventional problem of the rotary encoder, there is a problem that information on equipment such as the number of pulses of the encoder is manually input by a receiver.

It is, therefore, an object of the present invention to provide a power conversion device and a method of controlling a power conversion device in which a circuit for storing parameters of an encoder is not required for a rotary encoder, and it is not necessary to manually set equipment information such as the number of pulses of the encoder.

## SOLUTION TO PROBLEM

In order to solve the above problem, for example, the configuration described in the claims is adopted.

The present application includes a plurality of means for solving the problem, and an example thereof is a "power conversion device for controlling an electric motor by converting an AC voltage or a DC voltage into any voltage by an operation of a switching circuit, including: a control circuit for controlling the operation of the switching circuit, wherein the control circuit obtains information on a position detector, a phase detector or a speed detector based on a signal from the position detector, the phase detector or the speed detector".

## ADVANTAGEOUS EFFECTS OF INVENTION

According to the present invention, it is possible to provide a power conversion device and a method of controlling a power conversion device in which a circuit for storing parameters of an encoder is not required for a rotary encoder, and it is not necessary to manually set equipment information on such as the number of pulses of the encoder.

The problems, configurations, and effects other than the above are clarified from the description of the embodiments below.

**BRIEF DESCRIPTION OF DRAWINGS**

[FIG.1] FIG. 1 is an example of a signal which a speed or a position detector outputs.
[FIG. 2] FIG.2 is an example of a signal which a speed or a position detector outputs.
[FIG. 3] FIG.3 is an example of a signal which a speed or a position detector outputs.
[FIG. 4] FIG.4 is an example of a signal which a speed or a position detector outputs.
[FIG. 5] FIG.5 shows an example of a configuration of embodiment in Embodiment 1.
[FIG. 6] FIG.6 shows an example of a configuration of embodiment in Embodiment 2.
[FIG. 7] FIG.7 shows an example of a configuration of embodiment in Embodiment 3.
[FIG. 8] FIG.8 shows an example of a configuration of embodiment in Embodiment 4.

**DESCRIPTION OF EMBODIMENTS**

Hereinafter, embodiments of the present invention will be described with reference to the drawings. In the following description, the same reference numerals are given to the constituent elements common to the respective drawings, and duplicate explanation thereof will be omitted.

A power conversion device that performs drive control of an electric motor using vector control needs a rotational speed or rotational position information on the electric motor, and it is common for the power conversion device to use a speed or a position detector.

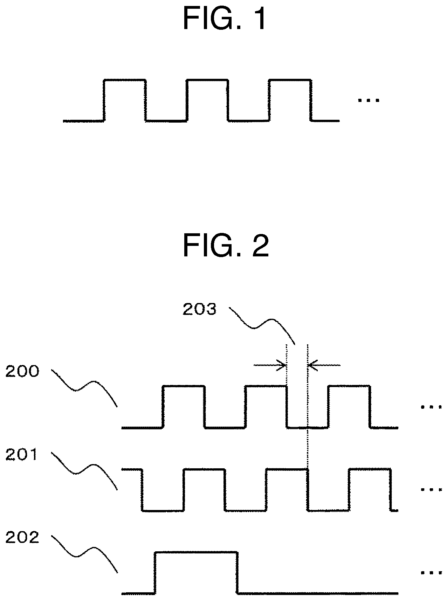

FIG. 1 is an example of a signal which a speed or a position detector outputs.

The signal shown in FIG. 1 is pulses whose ON and OFF widths are equal, and the predetermined number of the pulses are output per rotation of the detector.

From the number of pulses per rotation of the detector, the rotational position is calculated as follows.

[MATH. 1]

MATH. 1

$$\text{rotational position} = \frac{2 \times \pi \times \text{pulse count number}}{\text{number of pulses per rotation}}$$

In addition, the rotational position may be calculated using a rising edge or a falling edge of the pulse. In that case, the rotational position can be calculated by replacing the pulse with the edge. When using the rising or the falling edge of a pulse, the number of edges per rotation of the detector is equal to the number of pulses per rotation of the detector.

Both edges of the pulse may be used for the purpose of improving accuracy. In this case, the number of edges per rotation of the detector is twice the number of pulses per rotation of the detector.

The rotational speed is calculated as follows.

[MATH. 2]

MATH. 2

$$\text{rotational speed} = \frac{2 \times \pi \times \text{pulse count number}}{\text{pulse count time} \times \text{number of pulses per rotation}}$$

In the case of using the edge, it is possible to calculate the rotational speed by replacing the pulse with the edge in the same manner as described above.

FIG. 2 is an example of a signal which a speed or a position detector outputs.

As in the case of the signal shown in FIG. 1, a signal 200 is pulses whose ON and OFF widths are equal, and the predetermined number of pulses per rotation of the detector are output. A signal 201 is the same pulse as the signal 200, and has a delay of 90° phase difference 203 from the signal 200. For a signal 202 one pulse per rotation of the detector is output, and the signal 202 is often used as a reference of the rotational position.

The rotational speed and the rotational position are calculated in the same manner as described above. In particular, both edges of the signal 200 and the signal 201 are often used for the purpose of improving accuracy. In this case, the number of edges per rotation of the detector is four times the number of pulses per rotation of the detector.

In addition, from the consideration of the 90° phase difference 203, for example, when the rising edge of the signal 201 is detected after the rising edge of the signal 200 is detected, the detector performs normal rotation, and when the falling edge is detected, the detector performs reverse rotation. Thus, by monitoring both edges, the direction of rotation will be known.

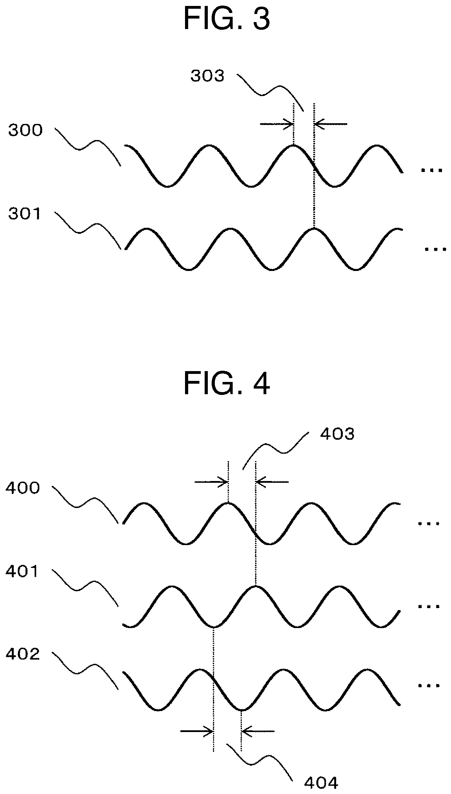

FIG. 3 is an example of a signal which a speed or a position detector outputs.

For a signal 300, the predetermined number of sine (cosine) wave cycles per rotation of the detector is output. A signal 301 is a sine (cosine) wave which is the same as the signal 300, and has a delay of 90° phase difference 303 from the signal 300.

The rotational speed, the rotation position, and the rotational direction can be calculated by the same method as described above by converting a sine (cosine) wave into a pulse. In that case, the number of pulses per rotation of the detector is equal to the number of cycles per rotation of the detector. Further, the rotational position may be calculated by tangent, or the rotational direction may be calculated from increase and decrease of the rotational position.

FIG. 4 is an example of a signal which a speed or a position detector outputs.

For a signal 400, the predetermined number of sine (cosine) wave cycles per rotation of the detector is output. A signal 401 is a sine (cosine) wave which is the same as the signal 400, and has a delay of 120° phase difference 303 from the signal 400. A signal 402 is a sine (cosine) wave which is the same as the signal 400, and has a delay of 120° phase difference 404 from the signal 401.

The rotational speed, the rotational position, and the rotational direction can be calculated in the same manner as described above by applying Clarke transformation.

When the detector is attached to the shaft of the electric motor, the rotational speed, the rotational position and the rotational direction of the detector and the rotational speed, the rotational position and the rotational direction of the electric motor are equal to each other.

Embodiment 1

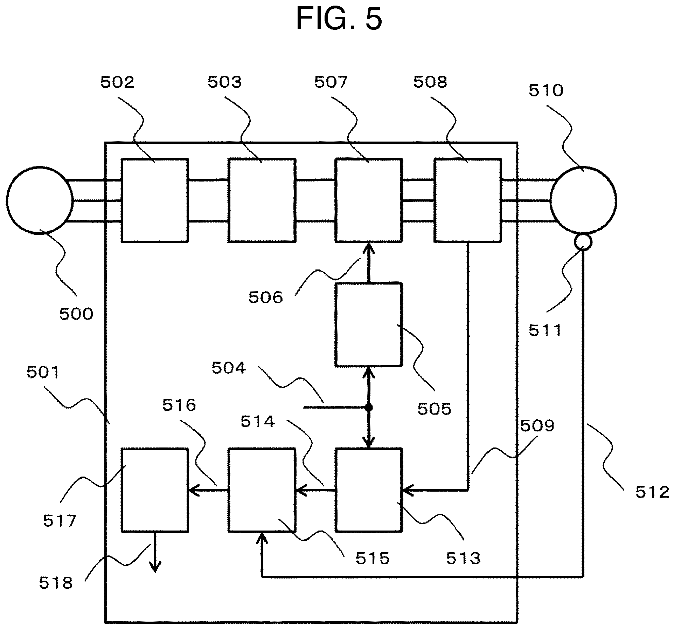

FIG. 5 is an example of the configuration of embodiment in Embodiment 1.

A power conversion device 501 that performs drive control of a three-phase AC induction motor 510 includes a rectifier circuit 502, a smoothing circuit 503, a switching circuit controller 505, a switching circuit 507, a current detector 508, a motor state estimation unit 513, a detector information estimation unit 515, and an abnormality determination unit 517. For convenience, the switching circuit controller 505, the motor state estimation unit 513, the detector information estimation unit 515, and the abnormality determination unit 517 are collectively referred to as a control unit.

The three-phase AC voltage output from the three-phase AC power supply 500 is rectified by the rectifier circuit 502, smoothed by the smoothing circuit 503, and a DC voltage is generated. A single-phase AC power supply may be used instead of the three-phase AC power supply 500 and a single-phase AC voltage may be input to the rectifier circuit 502. Further, instead of the AC power supply, a direct current voltage may be directly provided using a DC power supply.

The switching circuit controller 505 generates a switching circuit control signal 506 so that the voltage based on a voltage instruction 504 is output from the switching circuit 507.

The switching circuit 507 converts a DC voltage into a three-phase AC voltage based on the switching circuit control signal 506.

The current detector 508 detects the three-phase AC current output from the switching circuit 507. Since the sum of three-phase AC currents is zero, only if two phases are detected, the remaining one phase may be calculated. Instead of the expensive current detector 508, an inexpensive shunt resistor may be provided on the positive electrode or the negative electrode of the smoothing circuit 503, and the three-phase AC current may be estimated from the current flowing through the shunt resistor.

A position detector 511 is attached to the electric motor. The position detector 511 outputs at least one signal of the predetermined number of pulses or the predetermined number of edges or the predetermined number of sine (cosine) waves cycles per rotation of the detector as rotational position information on the electric motor. Examples of the position detector include, for example, an encoder, a resolver, a Hall sensor or the like. In cases where a plurality of signals are output, each signal may have the different number of pulses or the different number of sine (cosine) cycles per rotation of the detector. There is a detector that detects an electrical angle, and a detector that detects a mechanical angle. Since both angles can be converted to each other with the number of poles (the number of the pair of poles) of the electric motor, they are treated as the same below.

The motor state estimation unit 513 estimates the rotational speed of the three-phase AC induction motor 510 based on at least one of the voltage instruction 504 and detection current 509. Methods for estimating the speed of the induction motor include, for example, a method described in JP-H6-105580A (PATENT LITERATURE 2). The rotational speed may be calculated by estimating the rotational position of the induction motor and using a calculus relationship between the rotational speed and the rotational position.

The detector information estimation unit 515 estimates detector information from the estimated rotational speed of an electric motor 514, and a detection position signal 512. When there are a plurality of detection position signals 512, detector information for each signal may be estimated. For example, it is possible to reduce the influence of noise and the like by estimating and averaging a plurality of detector information.

The abnormality determination unit 517 determines whether estimated detector information 516 satisfies the condition which has been set inside in advance or set from outside, and outputs an alarm signal 518. When there is a plurality of estimated detector information 516, a condition may be set for each detector information and an alarm signal 518 may be output based on at least one of them. Further, an alarm signal 518 may also be output based on at least two of the estimated detector information 516. By outputting an alarm signal based on the plurality of estimated detector information, it is possible to more reliably inform users of the abnormality of the detector information. A condition for outputting the alarm signal 518 is such that for example, when the number of pulses, the number of edges, or the number of cycles per rotation of the detector deviates from a range settable for the power conversion device, an alarm signal 518 is output, or when the number of pulses, the number of edges, or the number of cycles per rotation of at least two detectors do not match, the alarm signal 518 is output.

Hereinafter, a method of estimating detector information will be described.

For example, the method described in JP-H6-105580A (PATENT LITERATURE 2) discloses that when the three-phase AC induction motor 510 is rotated at any rotational speed, the estimated rotational speed of the electric motor 514 and the detection position signal 512 based on the rotational speed are input to the detector information estimation unit 515. The detector information estimation unit 515 can provide the number of pulses per rotation of the electric motor as shown below from the estimated rotational speed of the electric motor 514 and the detection position signal 512 which has been input.

[MATH. 3]

MATH. 3

$$\text{number of pulses per rotation of the electric motor} = \frac{2 \times \pi \times \text{pulse count number}}{\text{pulse count time} \times \text{estimated rotational speed of the electric motor}}$$

The pulse count number and the pulse count time of MATH. 3 may be the difference from those at the previous estimation time.

When the position detector 511 is mounted on the axis of the three-phase AC induction motor 510, the number of pulses per rotation of the electric motor is equal to the number of pulses per rotation of the detector, so that detector information can be provided.

In the case of a pulse edge or a sine (cosine) wave, the pulse may be replaced with an edge or a cycle in the same manner as described above.

When the detector information estimation unit 515 determines that the set value and the estimated value of the electric power conversion device are different to each other with respect to the detector information such as the number of pulses per rotation, the set value is replaced with the estimated value, which may be used to calculate the rotational speed and rotational position.

Embodiment 2

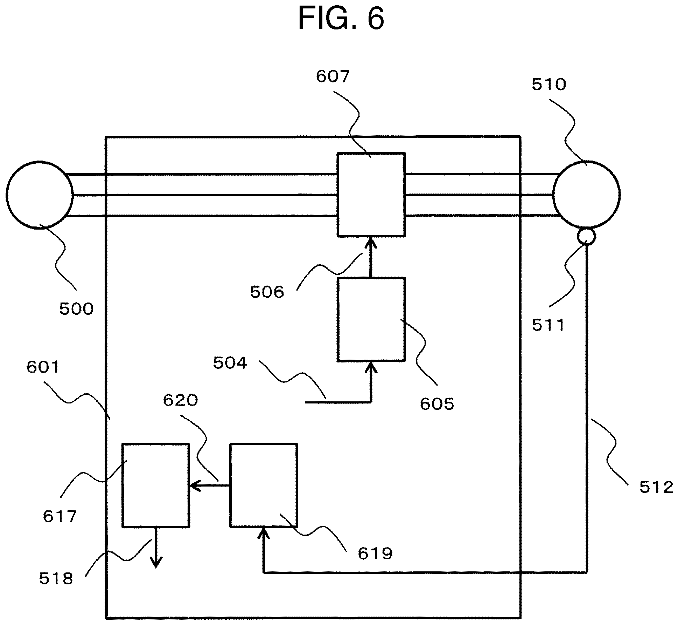

FIG. 6 is an example of the configuration of embodiment in Embodiment 2.

The power conversion device 601 that performs drive control of the three-phase AC induction motor 510 includes a switching circuit controller 605, a switching circuit 607, an abnormality determination unit 617, and a wiring state estimation unit 619. For convenience, the switching circuit controller 605, the abnormality determination unit 617, and the wiring state estimation unit 619 are collectively referred to as a control unit.

The switching circuit controller 605 generates the switching circuit control signal 506 so that the voltage based on the voltage instruction 504 is output from the switching circuit 607.

The switching circuit 607 converts the three-phase AC voltage output from the three-phase AC power supply 500 into a three-phase AC voltage based on the switching circuit control signal 506.

The wiring state estimation unit 619 estimates the wiring state from the detection position signal 512. When there is a plurality of detection position signals 512, an estimated wiring state 620 for each signal may be estimated.

Further, as described above, the power conversion device includes the current detector and the motor state estimation unit, and the rotational speed and the rotational position of the electric motor may be estimated and the wiring state may be estimated based on the detection position signal and the rotational speed or the rotational position.

The abnormality determination unit 617 determines whether the estimated wiring state 620 satisfies the condition which is preset inside thereof or set from the outside, and outputs an alarm signal 518. When there is a plurality of estimated wiring states 620, the condition may be set for each detector information and an alarm signal 518 may be output based on at least one of them. Further, the alarm signal 518 also may be output based on at least two of the estimated wiring states 620. By outputting an alarm signal based on the plurality of estimated wiring states, it is possible to inform users of the abnormality of the wiring state more reliably. A condition for outputting the alarm signal 518 is such that, for example, when the estimated wiring phase sequence of the power conversion device 601 and the position detector 511 is different from the set wiring phase sequence of the power conversion device 601 and the position detector 511, an alarm signal 518 is output, or when at least two estimated wiring phase sequences do not match, an alarm signal 518 is output, or when at least one wire is disconnected, an alarm signal 518 is output, or the like.

Hereinafter, a method of estimating the wiring state 620 will be described.

For example, when the three-phase AC induction motor 510 is rotated at a rotational speed under constant V/f control, a detection position signal 512 based on the rotational speed is input to the wiring state estimation unit 619. The wiring state estimation unit 619 calculates the rotational direction of the detector by the above-described method or the like, for example. From the calculated rotational direction, the phase relationship of the detection position signal 512 which has been input, that is, the phase sequence of the wiring between the power conversion device 601 and the position detector 511 will be known.

In addition, when the wiring between the power conversion device 601 and the position detector 511 is disconnected, even if the three-phase AC induction motor 510 rotates, only the pulse of the disconnected wire remains ON or OFF. Therefore, when a signal whose pulse remains ON or OFF exists among the detection position signals 512 input to the wiring state estimation unit 619, the wiring is determined to be disconnected.

In this way, it is possible to estimate the wiring state such as wiring phase sequence and disconnection without using the motor state estimation unit.

The power conversion device 601 may be provided with a motor state estimation unit, so that the rotational speed of the electric motor and the rotational position of the electric motor can be estimated, and the wiring state using the estimated rotational speed of the electric motor or the estimated rotational position of the electric motor can be estimated. From the rotational direction that can be calculated from the sign of the estimated rotational speed of the electric motor and the increase and decrease in the estimated rotational position of the electric motor, and the rotational direction that can be calculated from the detection position signal 512, the wiring phase sequence will be known. Further, by comparing the estimated rotational speed of the electric motor or the estimated rotational position of the electric motor with the rotational speed or rotational position that can be calculated from the detection position signal 512, it is possible to determine whether the wiring is disconnected.

In the case of pulse edges or sine (cosine) waves, it is possible to estimate the wiring state in the same manner.

For example, when the wiring state estimation unit 619 determines that the setting wiring state and the estimated wiring state of the power conversion device is different from each other with respect to the wiring state such as the phase sequence of the wiring, the setting wiring state is replaced with the estimated wiring state, which may be used for calculating the rotational direction.

Embodiment 3

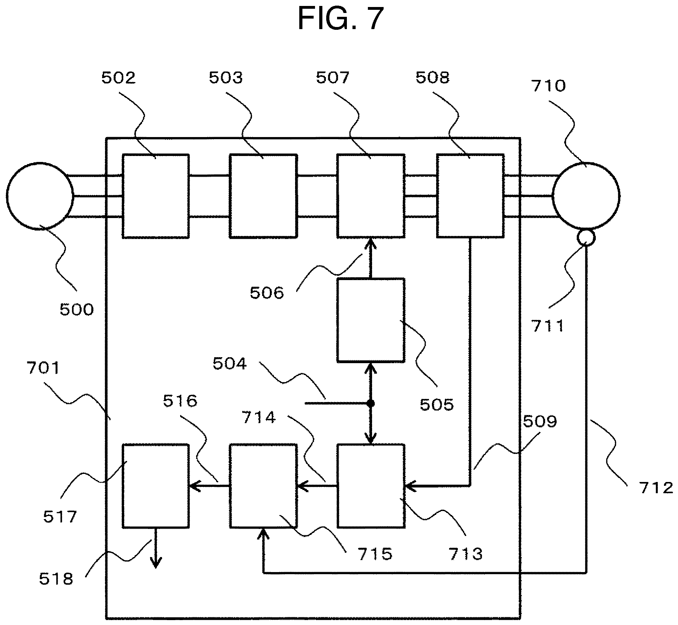

FIG. 7 is an example of the configuration of embodiment in Embodiment 3.

A power conversion device 701 that performs drive control of a three-phase AC permanent magnet synchronous motor 710 includes a rectifier circuit 502, a smoothing circuit 503, a switching circuit controller 505, a switching circuit 507, a current detector 508, a motor state estimation unit 713, a detector information estimation unit 715, and an abnormality determination unit 517. For convenience, the switching circuit controller 505, the motor state estimation unit 713, the detector information estimation unit 715, and the abnormality determination unit 517 are collectively referred to as a control unit.

A speed detector 711 detects the rotational speed of the detector. There are a detector that detects an electrical angle speed and a detector that detects a mechanical angle speed. Since both angle speeds can be converted to each other with the number of poles (the number of the pair of poles) of the electric motor, they are treated as the same below.

The motor state estimation unit 713 estimates the rotational position of the three-phase AC permanent magnet synchronous motor 710 based on at least one of the voltage instruction 504 and the detection current 509. Methods of estimating the position of the permanent magnet synchronous motor include a method, for example, described in JP-2001-251889A (PATENT LITERATURE 3). The rotational position of the permanent magnet synchronous motor may be calculated by estimating the rotational speed of the permanent magnet synchronous motor and by utilizing the fact that the rotational speed and the rotational position have a calculus relationship.

The detector information estimation unit 715 estimates the detector information from an estimated rotational position of the electric motor 714 and the detection speed signal 712. For example, when the detection speed signal 712 is an analog quantity such as a voltage or a current, the detector information to be estimated has a relation with the analog quantity and the rotational speed of the detector. For example, when the analog quantity and the rotational speed of the detector are in a proportional relation, the detector information includes inclination (gain), intercept (bias), and the like. For example, by comparing the increase/decrease in the estimated rotational position of the electric motor 714 with the increase/decrease in the detection speed signal 712, the rotational direction of the detector will be also known.

A condition for outputting the alarm signal 518 from the abnormality determination unit 517 is such that, for example, the value of inclination or intercept deviates from the predetermined range, an alarm signal 518 is output, or at least two conversion gains and bias values do not match.

Further, the power conversion device 701 is provided with a wiring state estimation unit, so that by comparing the detection speed signal 712 with the rotational speed that can be calculated from the estimated rotational position of the electric motor 714, the wiring state between the power conversion device 701 and the speed detector 711, for example, disconnection of the wiring, will be known.

Even when the position detector instead of the speed detector 711 is attached to the three-phase AC permanent magnet synchronous motor 710, since the rotational speed and the rotational position have a calculus relationship, it is also possible to estimate the detector information and the wiring state in the same manner.

Embodiment 4

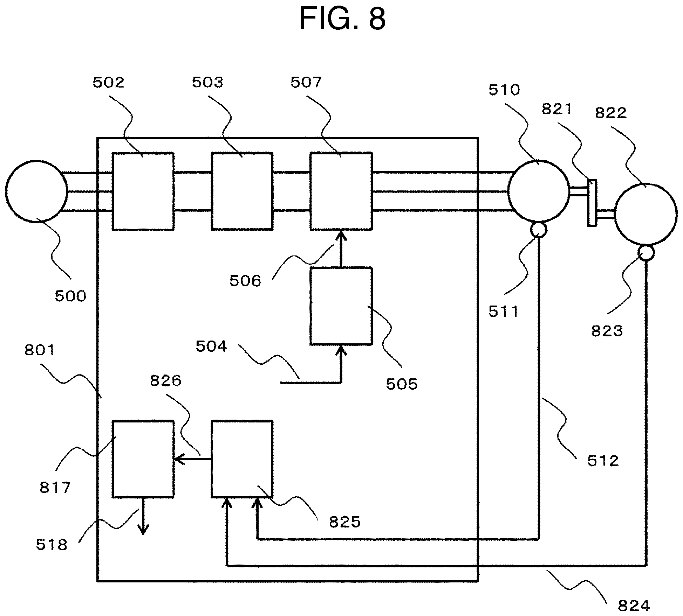

FIG. 8 shows an example of the configuration of embodiment in Embodiment 4.

A power conversion device 801 that performs drive control of the three-phase AC induction motor 510 includes a rectifier circuit 502, a smoothing circuit 503, a switching circuit controller 505, a switching circuit 507, an abnormality determination unit 817, and a relationship estimation unit 825. For convenience, the switching circuit controller 505, the abnormality determination unit 817, and the relationship estimation unit 825 are collectively referred to as a control unit.

A load device 822 is connected to the three-phase AC induction motor 510 via a transmission mechanism 821. The transmission mechanism 821 includes, for example, a gear, a chain, a belt, and the like.

A position detector 823 is attached to the load device 822, and outputs at least one signal of the predetermined number of pulses or the predetermined number of edges or the predetermined number of sine (cosine) wave cycles per rotation of the detector. When outputting a plurality of signals, the number of pulses or the number of sine (cosine) cycles per rotation of the detector may be different for each signal.

The relationship estimation unit 825 estimates the relationship between the three-phase AC induction motor 510 and the load device 822 based on the detection position signal 512 and a detection position signal 824. Since the rotational speed and rotational position have a calculus relationship with each other, a speed detector instead of the position detector is attached to the three-phase AC induction motor 510 and the load device 822, and based on the detection speed, the relationship between the three-phase AC induction motor 510 and the load device 822 may be estimated. The estimated relationship includes, for example, the rotational speed ratio and the rotational position ratio. Transmission mechanism information such as the gear ratio and the pulley diameter may be calculated from the rotational speed ratio and the rotational position ratio. The number of estimated relationships or the number of transmission mechanism information may be plural.

The abnormality determination unit 817 determines whether the estimated relationship 826 satisfies a condition preset inside in the abnormality determination unit 817 or a condition set from the outside and outputs an alarm signal 518. If there is a plurality of estimated relationships 826, a condition may be set for each detector information and an alarm signal 518 may be output based on at least one of the detector information. By outputting an alarm signal based on the plurality of estimated relationships, it is possible to inform users of the abnormality of the relationship more reliably. A condition for outputting the alarm signal 518 is such that, for example, when the estimated relationship 826 deviates from the predetermined range, an alarm signal 518 is output or the like. An alarm signal 518 may be output based on the estimated transmission mechanism information instead of the estimated relationship 826.

Further, the power conversion device 801 is provided with a detector information estimation unit and a wiring state estimation unit, so that the detector information estimation unit and the wiring state estimation unit may estimate the detector information and the wiring state based on the detection signal from the speed or the position detector attached to the load device 822. At that time, the power conversion device 801 is provided with a current detector and a motor information estimation unit, so that the current detector and the electric motor information estimation unit may estimate the detector information and the wiring state based on the estimated rotational speed of the electric motor and the rotational position of the electric motor.

The estimations of detector information or the wiring state, or the relationship or the transmission mechanism information, which are described above, may be performed at the timing specified by users. These estimates may be performed automatically when the wiring of the power conversion device and the speed or the position detector is completed.

In the above-described examples, explanation has been mainly made on the detector for detecting the rotational speed and the rotational position. A detector for detecting linear velocity and linear displacement can be applied in the same manner.

This invention is not limited to the above-described embodiments but includes various modifications. The above-described embodiments are explained in details for better understanding of this invention and are not limited to those including all the configurations described above. A part of the configuration of one embodiment may be replaced with that of another embodiment; the configuration of one embodiment may be incorporated to the configuration of another embodiment. A part of the configuration of each embodiment may be added, deleted, or replaced by that of a different configuration. The above-described configurations, functions, processors, process means and the like, for all or a part of them, may be implemented by hardware: for example, by designing with an integrated circuit. The above-described configurations and functions may be implemented by software, which means that a processor interprets and executes programs providing the functions. The information of programs, tables, and files to implement the functions may be stored in a storage device such as a memory, a hard disk drive, or an SSD (Solid State Drive), or a storage medium such as an IC card, an SD card, or a DVD.

**REFERENCE SIGNS LIST**

| | |
|---|---|
| 203, 303 200, 201, 202, 300, 301, 400, 401, 402 403, 404 | signal, 90° phase difference, 120° phase difference, |
| 500 | three-phase AC power supply, |
| 501 | power conversion device, |
| 502 | rectifier circuit, |
| 503 | smoothing circuit, |
| 504 | voltage instruction, |
| 505 | switching circuit controller, |
| 506 | switching circuit control signal, |
| 507 | switching circuit, |
| 508 | current detector, |
| 509 | detection current, |
| 510 | three-phase AC induction motor, |
| 511 | position detector, |
| 512 | detection position signal, |
| 513 | motor state estimation unit, |
| 514 | estimated rotational speed of electric motor, |
| 515 | detector information estimation unit, |
| 516 | detector information, |
| 517 | abnormality determination unit, |
| 518 | alarm signal, |
| 601 | power conversion device, |
| 605 | switching circuit controller, |
| 607 | switching circuit, |
| 617 | abnormality determination unit, |
| 619 | wiring state estimation unit, |
| 620 | estimated wiring state, |
| 701 | power conversion device, |
| 710 | three-phase AC permanent magnet synchronous motor, |
| 711 | speed detector, |
| 712 | detection speed signal, |
| 713 | motor state estimation unit, |
| 714 | estimated rotational position of the electric motor, |
| 715 | detector information estimation unit, |
| 801 | power conversion device, |
| 817 | abnormality determination unit, |
| 821 | transmission mechanism, |

| 822 | load device, |
| 823 | position detector, |
| 824 | detection position signal, |
| 825 | relationship estimation unit, |
| 826 | estimated relationship |

**Claims**

1. A power conversion device for controlling an electric motor (510) by converting an AC voltage or a DC voltage into any voltage by an operation of a switching circuit (507), comprising:

   a control circuit (505) for controlling the operation of the switching circuit (507),
   wherein the control circuit (505) is configured to obtain information on a position detector (511), a phase detector or a speed detector (711) based on a signal from the position detector (511), the phase detector or the speed detector (711) attached to the electric motor or a load device connected to the electric motor,

   **characterized in that** said information is:

   - a relationship between the electric motor and a load device connected to the electric motor, or
   - information on a transmission mechanism for connecting the electric motor and the load device.

2. The power conversion device according to claim 1,
   wherein information on the position detector (511), the phase detector, or the speed detector (711) further includes the number of pulses, the number of edges, the number of sine wave cycles, or the number of cosine wave cycles per rotation thereof.

3. A power conversion device according to claim 1, wherein said information further includes information on a wiring state between the power conversion device, and a position detector (511), a phase detector or a speed detector (711) and wherein said information on the wiring state is obtained based on a signal from the position detector (511), the phase detector or the speed detector (711).

4. The power conversion device according to claim 3,
   wherein the wiring state is a wiring phase sequence or a disconnection.

5. The power conversion device according to claim 1,
   wherein the position detector (511), the phase detector or the speed detector (711) is an encoder, a resolver or a Hall element.

6. The power conversion device according to claim 1,
   wherein the control device processes a signal based on the detector information, the wiring state, the relationship or the transmission mechanism information which have been obtained.

7. The power conversion device according to claim 1, further comprising:

   an abnormality determination unit,
   wherein the abnormality determination unit determines whether the detector information, the wiring state, the relationship or the transmission mechanism information is abnormal or not based on the detector information, the wiring state, the relationship or the transmission mechanism information which have been obtained, and outputs an alarm signal when determined as abnormal.

8. A control method for a power conversion device for controlling an electric motor by converting an AC voltage or a DC voltage into any voltage by an operation of a switching circuit, comprising the step of:

   controlling the operation of the switching circuit,
   wherein the control step includes obtaining information on a position detector (511), a phase detector or a speed detector (711) based on a signal from the position detector (511), the phase detector, or the speed detector (711) attached to the electric motor or a load device connected to the electric motor,

**characterized in that** said information is

- a relationship between the electric motor and a load device connected to the electric motor, or
- information on a transmission mechanism for connecting the electric motor and the load device.

9. The control method for a power conversion device according to claim 8,
wherein information on the position detector (511), the phase detector, or the speed detector (711) further includes the number of pulses, the number of edges, the number of sine wave cycles, or the number of cosine wave cycles number per rotation thereof.

10. A control method for a power conversion device according to claim 8,
wherein the control step further includes obtaining a wiring state between the power conversion device, and a position detector (511), a phase detector or a speed detector (711) based on a signal from the position detector (511), the phase detector or the speed detector (711).

11. The control method for a power conversion device according to claim 10,
wherein the wiring state is a wiring phase sequence or a disconnection.

12. A control method for a power conversion device according to claim 8,
wherein the control step further includes obtaining a relationship between the electric motor and a load device connected to the electric motor or information on a transmission mechanism for connecting the electric motor and the load device based on a signal from a position detector (511) or a phase detector or a speed detector (711).

13. The control method for a power conversion device according to claim 8,
wherein the position detector (511), the phase detector or the speed detector (711) is an encoder, a resolver or a Hall element.

14. The control method for a power conversion device according to claim 8,
wherein the control step includes processing a signal based on the detector information, the wiring state, the relationship, or the transmission mechanism information which have been obtained.

15. The control method for a power conversion device according to claim 8 further comprising the step of:

further determining an abnormality,
wherein the abnormality determining step includes determining whether the detector information, the wiring state, the relationship or the transmission mechanism information is abnormal or not based on the detector information, the wiring state, the relationship or the transmission mechanism information which have been obtained, and outputting an alarm signal when determined as abnormal.

**Patentansprüche**

1. Leistungsumwandlungsvorrichtung zum Steuern eines Elektromotors (510) durch Umwandeln einer Wechselspannung oder einer Gleichspannung in eine beliebige Spannung durch eine Betätigung eines Schaltkreises (507), umfassend:

eine Steuerschaltung (505) zum Steuern des Betriebs des Schaltkreises (507),
wobei die Steuerschaltung (505) dazu ausgelegt ist, Informationen über einen Positionsdetektor (511), einen Phasendetektor oder einen Geschwindigkeitsdetektor (711) auf der Grundlage eines Signals des Positionsdetektors (511), des Phasendetektors oder des Geschwindigkeitsdetektors (711), der an dem Elektromotor angebracht ist, oder einer Lastvorrichtung, die mit dem Elektromotor verbunden ist, zu erhalten,

**dadurch gekennzeichnet, dass** diese Information ist:

eine Beziehung zwischen dem Elektromotor und einer mit dem Elektromotor verbundenen Lastvorrichtung, oder Informationen über einen Übertragungsmechanismus zur Verbindung des Elektromotors mit der Lastvorrichtung.

2. Die Leistungsumwandlungsvorrichtung nach Anspruch 1,
wobei Informationen über den Positionsdetektor (511), den Phasendetektor oder den Geschwindigkeitsdetektor (711) ferner die Anzahl von Impulsen, die Anzahl von Flanken, die Anzahl von Sinuswellenzyklen oder die Anzahl von Cosinuswellenzyklen pro Umdrehung umfassen.

3. Leistungsumwandlungsvorrichtung nach Anspruch 1, wobei die Information ferner Informationen über einen Verdrahtungszustand zwischen der Leistungsumwandlungsvorrichtung und einem Positionsdetektor (511), einem Phasendetektor oder einem Geschwindigkeitsdetektor (711) enthält und wobei die Information über den Verdrahtungszustand auf der Grundlage eines Signals von dem Positionsdetektor (511), dem Phasendetektor oder dem Geschwindigkeitsdetektor (711) gewonnen wird.

4. Die Leistungsumwandlungsvorrichtung nach Anspruch 3,
wobei der Verdrahtungszustand eine Verdrahtungsphasenfolge oder eine Trennung ist.

5. Die Leistungsumwandlungsvorrichtung nach Anspruch 1,
wobei der Positionsdetektor (511), der Phasendetektor oder der Geschwindigkeitsdetektor (711) ein Codierer, ein Resolver oder ein Hall-Element ist.

6. Die Leistungsumwandlungsvorrichtung nach Anspruch 1,
wobei die Steuervorrichtung ein Signal verarbeitet, das auf der Detektorinformation, dem Verdrahtungszustand, der Beziehung oder der Übertragungsmechanismus-Information basiert, die erhalten worden sind.

7. Die Leistungsumwandlungsvorrichtung nach Anspruch 1, ferner umfassend:

eine Einheit zur Bestimmung von Anomalien,
wobei die Einheit zur Bestimmung von Anomalien basierend auf der Detektorinformation, dem Verdrahtungszustand, der Beziehung oder der Übertragungsmechanismus-Information, die erhalten wurden, bestimmt, ob die Detektorinformation, der Verdrahtungszustand, die Beziehung oder die Übertragungsmechanismus-Information anormal ist oder nicht, und gibt Alarmsignal ausgibt, wenn sie als anormal bestimmt wird.

8. Steuerverfahren für eine Leistungsumwandlungsvorrichtung zum Steuern eines Elektromotors durch Umwandeln einer Wechselspannung oder einer Gleichspannung in eine beliebige Spannung durch eine Betätigung eines Schaltkreises, das den folgenden Schritt umfasst:

Steuerung des Betriebs des Schaltkreises,
wobei der Steuerschritt das Erhalten von Informationen über einen Positionsdetektor (511), einen Phasendetektor oder einen Geschwindigkeitsdetektor (711) auf der Grundlage eines Signals von dem Positionsdetektor (511), dem Phasendetektor oder dem Geschwindigkeitsdetektor (711), der an dem Elektromotor angebracht ist, oder einer Lastvorrichtung, die mit dem Elektromotor verbunden ist, umfasst,

**dadurch gekennzeichnet, dass** die Information

- eine Beziehung zwischen dem Elektromotor und einer mit dem Elektromotor verbundenen Lastvorrichtung, oder
- Information über einen Übertragungsmechanismus zur Verbindung des Elektromotors und der Lastvorrichtung

ist.

9. Steuerverfahren für eine Leistungsumwandlungsvorrichtung nach Anspruch 8,
wobei Informationen über den Positionsdetektor (511), den Phasendetektor oder den Geschwindigkeitsdetektor (711) ferner die Anzahl von Impulsen, die Anzahl von Flanken, die Anzahl von Sinuswellenzyklen oder die Anzahl von Cosinuswellenzyklen pro Umdrehung umfassen.

10. Steuerverfahren für eine Leistungsumwandlungsvorrichtung nach Anspruch 8,
wobei der Steuerschritt ferner das Ermitteln eines Verdrahtungszustands zwischen der Leistungsumwandlungsvorrichtung und einem Positionsdetektor (511), einem Phasendetektor oder einem Geschwindigkeitsdetektor (711) basierend auf einem Signal des Positionsdetektors (511), des Phasendetektors oder des Geschwindigkeitsdetektors (711) umfasst.

**11.** Steuerungsverfahren für eine Leistungsumwandlungsvorrichtung nach Anspruch 10,
wobei der Verdrahtungszustand eine Verdrahtungsphasenfolge oder eine Trennung ist.

**12.** Steuerverfahren für eine Leistungsumwandlungsvorrichtung nach Anspruch 8,
wobei der Steuerschritt ferner das Ermitteln einer Beziehung zwischen dem Elektromotor und einer Lastvorrichtung,
die mit dem Elektromotor verbunden ist, oder von Informationen über einen Übertragungsmechanismus zum Verbinden des Elektromotors und der Lastvorrichtung auf der Grundlage eines Signals von einem Positionsdetektor
(511) oder einem Phasendetektor oder einem Geschwindigkeitsdetektor (711) umfasst.

**13.** Steuerungsverfahren für eine Leistungsumwandlungsvorrichtung nach Anspruch 8,
wobei der Positionsdetektor (511), der Phasendetektor oder der Geschwindigkeitsdetektor (711) ein Codierer, ein
Resolver oder ein Hall-Element ist.

**14.** Steuerungsverfahren für eine Leistungsumwandlungsvorrichtung nach Anspruch 8,
wobei der Steuerschritt die Verarbeitung eines Signals auf der Grundlage der erhaltenen Detektorinformation, des
Verdrahtungszustands, der Beziehung oder der Übertragungsmechanismus-Information umfasst.

**15.** Steuerverfahren für eine Leistungsumwandlungsvorrichtung nach Anspruch 8, ferner umfassend den folgenden
Schritt:

weitere Bestimmung einer Anomalie,
wobei der Schritt des Bestimmens der Anomalie das Bestimmen, ob die Detektorinformation, der Verdrahtungszustand, die Beziehung oder die Übertragungsmechanismus-Information anomal ist oder nicht, basierend auf
der Detektorinformation, dem Verdrahtungszustand, der Beziehung oder der Übertragungsmechanismus-Information, die erhalten wurden, und das Ausgeben eines Alarmsignals, wenn als anomal bestimmt, einschließt.


**Revendications**

**1.** Dispositif de conversion de puissance pour commander un moteur électrique (510) par conversion d'une tension
alternative ou d'une tension continue en n'importe quelle tension par le fonctionnement d'un circuit de commutation
(507), comprenant :

un circuit de commande (505) pour commander le fonctionnement du circuit de commutation (507),
dans lequel le circuit de commande (505) est conçu pour obtenir des informations sur un détecteur de position
(511), un détecteur de phase ou un détecteur de vitesse (711) sur la base d'un signal provenant du détecteur
de position (511), du détecteur de phase ou du détecteur de vitesse (711) attaché au moteur électrique ou à
un dispositif de charge connecté au moteur électrique,

**caractérisé en ce que** lesdites informations sont :

- une relation entre le moteur électrique et un dispositif de charge connecté au moteur électrique, ou
- des informations sur un mécanisme de transmission pour connecter le moteur électrique et le dispositif de
charge.

**2.** Dispositif de conversion de puissance selon la revendication 1,
dans lequel les informations sur le détecteur de position (511), le détecteur de phase ou le détecteur de vitesse
(711) comprennent en outre le nombre d'impulsions, le nombre de fronts, le nombre de cycles d'onde sinusoïdale,
ou le nombre de cycles d'onde cosinusoïdale par rotation de celui-ci.

**3.** Dispositif de conversion de puissance selon la revendication 1, dans lequel lesdites informations comprennent en
outre des informations sur un état de câblage entre le dispositif de conversion de puissance et un détecteur de
position (511), un détecteur de phase ou un détecteur de vitesse (711) et dans lequel lesdites informations sur l'état
de câblage sont obtenues sur la base d'un signal provenant du détecteur de position (511), du détecteur de phase
ou du détecteur de vitesse (711).

**4.** Dispositif de conversion de puissance selon la revendication 3,
dans lequel l'état de câblage est une séquence de phases de câblage ou une déconnexion.

**5.** Dispositif de conversion de puissance selon la revendication 1,
dans lequel le détecteur de position (511), le détecteur de phase ou le détecteur de vitesse (711) est un codeur, un résolveur ou un élément Hall.

**6.** Dispositif de conversion de puissance selon la revendication 1,
dans lequel le dispositif de commande traite un signal basé sur les informations de détecteur, l'état de câblage, la relation ou les informations de mécanisme de transmission qui ont été obtenus.

**7.** Dispositif de conversion de puissance selon la revendication 1, comprenant en outre :

une unité de détermination d'anomalie,
dans lequel l'unité de détermination d'anomalie détermine si les informations de détecteur, l'état de câblage, la relation ou les informations de mécanisme de transmission sont anormaux ou non sur la base des informations de détecteur, de l'état de câblage, de la relation ou des informations de mécanisme de transmission qui ont été obtenus, et émet en sortie un signal d'alarme lorsqu'ils sont déterminés comme anormaux.

**8.** Procédé de commande pour un dispositif de conversion de puissance pour commander un moteur électrique par conversion d'une tension alternative ou d'une tension continue en n'importe quelle tension par le fonctionnement d'un circuit de commutation, comprenant l'étape de :

commande du fonctionnement du circuit de commutation,
dans lequel l'étape de commande comprend l'obtention d'informations sur un détecteur de position (511), un détecteur de phase ou un détecteur de vitesse (711) sur la base d'un signal provenant du détecteur de position (511), du détecteur de phase ou du détecteur de vitesse (711) attaché au moteur électrique ou à un dispositif de charge connecté au moteur électrique,

**caractérisé en ce que** lesdites informations sont

- une relation entre le moteur électrique et un dispositif de charge connecté au moteur électrique, ou
- des informations sur un mécanisme de transmission pour connecter le moteur électrique et le dispositif de charge.

**9.** Procédé de commande pour un dispositif de conversion de puissance selon la revendication 8,
dans lequel les informations sur le détecteur de position (511), le détecteur de phase ou le détecteur de vitesse (711) comprennent en outre le nombre d'impulsions, le nombre de fronts, le nombre de cycles d'onde sinusoïdale, ou le nombre de cycles d'onde cosinusoïdale par rotation de celui-ci.

**10.** Procédé de commande pour un dispositif de conversion de puissance selon la revendication 8,
dans lequel l'étape de commande comprend en outre l'obtention d'un état de câblage entre le dispositif de conversion de puissance, et un détecteur de position (511), un détecteur de phase ou un détecteur de vitesse (711) sur la base d'un signal provenant du détecteur de position (511), du détecteur de phase ou du détecteur de vitesse (711).

**11.** Procédé de commande pour un dispositif de conversion de puissance selon la revendication 10,
dans lequel l'état de câblage est une séquence de phases de câblage ou une déconnexion.

**12.** Procédé de commande pour un dispositif de conversion de puissance selon la revendication 8,
dans lequel l'étape de commande comprend en outre l'obtention d'une relation entre le moteur électrique et un dispositif de charge connecté au moteur électrique ou d'informations sur un mécanisme de transmission pour connecter le moteur électrique et le dispositif de charge sur la base d'un signal provenant d'un détecteur de position (511) ou d'un détecteur de phase ou d'un détecteur de vitesse (711).

**13.** Procédé de commande pour un dispositif de conversion de puissance selon la revendication 8,
dans lequel le détecteur de position (511), le détecteur de phase ou le détecteur de vitesse (711) est un codeur, un résolveur ou un élément Hall.

**14.** Procédé de commande pour un dispositif de conversion de puissance selon la revendication 8,
dans lequel l'étape de commande comprend le traitement d'un signal basé sur les informations de détecteur, l'état de câblage, la relation ou les informations de mécanisme de transmission qui ont été obtenus.

**15.** Procédé de commande pour un dispositif de conversion de puissance selon la revendication 8 comprenant en outre l'étape de :

détermination en outre d'une anomalie,
dans lequel l'étape de détermination d'anomalie comprend la détermination si les informations de détecteur, l'état de câblage, la relation ou les informations de mécanisme de transmission sont anormaux ou non sur la base des informations de détecteur, de l'état de câblage, de la relation ou des informations de mécanisme de transmission qui ont été obtenus, et l'émission en sortie d'un signal d'alarme lorsqu'ils sont déterminés comme anormaux.

# FIG. 1

# FIG. 2

# FIG. 3

# FIG. 4

# FIG. 5

# FIG. 6

# FIG. 7

# FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H95114 A
- US 2242173 A1
- US 5455 A
- US 749 A
- JP 2007185006 A

- JP 2010276417 A
- JP H08336299 A
- JP H6105580 A
- JP 2001251889 A